# DEMANDE DE BREVET EUROPEEN

(11) **EP 1 130 724 A1**
(43) Date de publication de la demande: **05.09.2001**
(21) Numéro de dépôt: 00810183.4
(22) Date de dépôt: 03.03.2000
(51) Int. Cl.: H01S 5/34, H01L 33/00

(54) **Laser à cascade quantique et procédé pour la fabrication d'un tel laser**

(71) Demandeur: Alpes Lasers, 2000 Neuchâtel (CH)
(72) Inventeur: Beck, Mattias, 2000 Neuchâtel (CH); Faist, Jérôme, 2000 Neuchâtel (CH); Muller, Antoine, 2000 Neuchâtel (CH)
(74) Mandataire: Gresset, Jean

(57) **Abrégé**

Laser semi-conducteur à cascade quantique, comportant
- un substrat (10),
- un empilement (12) de couches, de forme prismatique à section sensiblement trapézoïdale, avec une face inférieure disposée sur le substrat (10), une face supérieure et des faces latérales, ledit empilement formant une région de gain et deux manteaux entre lesquels la région de gain est interposée,
- deux électrodes (10, 24) disposées de part et d'autre de l'empilement (12), dont l'une (24) est formée par une couche de matériau électriquement conducteur recouvrant au moins partiellement la face de l'empilement opposée au substrat, et
- une couche électriquement isolante (22) interposée entre les deux électrodes.

Selon l'invention, la couche électriquement isolante (22) recouvre totalement les faces latérales du prisme, sans déborder sur la face supérieure, et son épaisseur est égale à au moins un tiers de l'épaisseur de l'empilement (12).

## Description

La présente invention concerne les lasers semi-conducteurs à cascade quantique. Dans la présente demande, on entend par laser semi-conducteur à cascade quantique un laser dans lequel le gain provient de porteurs effectuant des transitions inter-sous-bandes dans une hétérostructure de semi-conducteurs.

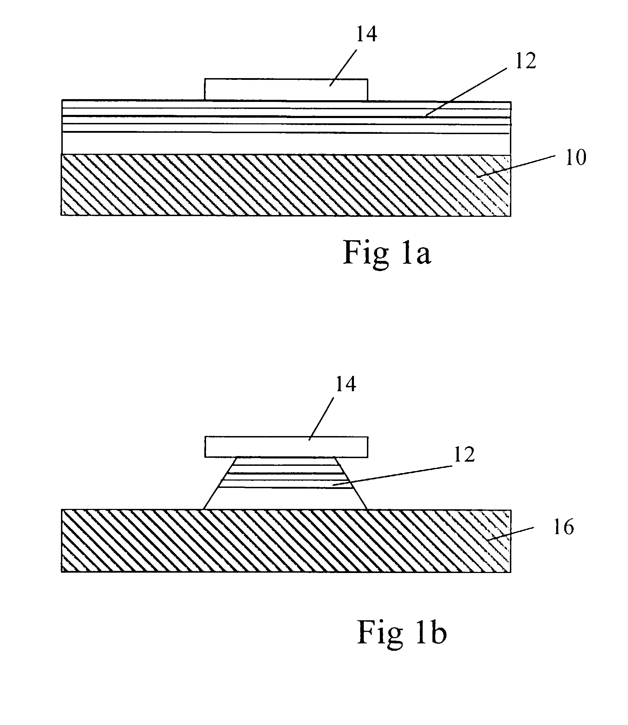

Un laser de ce type est, par exemple, décrit dans le document intitulé "Buried heterostructure quantum cascade lasers", publié dans SPIE Vol. 3284 0277-786X98. Sa structure et le procédé de fabrication mis en oeuvre seront expliqués de manière détaillée dans la description qui va suivre, en référence à la figure 1.

De tels lasers comportent un substrat en phosphure d'indium (InP), dopé au silicium, sur lequel est disposé un empilement de couches très minces formant le guide d'onde du laser. L'empilement a une structure prismatique, de section sensiblement trapézoïdale, dont la face inférieure, qui forme la grande base du trapèze, repose sur le substrat.

Les faces inférieure et supérieure sont formées chacune par des couches d'alliages d'arséniure d'indium et de gallium (InGaAs), et d'arséniure d'indium et d'aluminium (AllnAs) constituant un manteau.

Une succession de couches d'arséniure d'aluminium et d'indium (AllnAs) et d'arséniure d'indium et de gallium (InGaAs) forme la région active du laser, qui est disposée entre les deux manteaux.

Pour assurer l'injection d'un courant électrique dans la région active, le laser comporte, en outre, deux électrodes. La première électrode est formée par le substrat. La seconde est réalisée au moyen d'une couche métallique disposée par-dessus le substrat et en contact sur, au moins, une partie de la face supérieure de l'empilement. Une couche électriquement isolante, en InP, supporte la couche métallique, à l'exception de la zone de contact.

La fabrication d'un tel laser fait appel à un substrat en InP dopé, de manière à le rendre conducteur, pour former la première électrode. Des couches successives sont ensuite déposées, qui constituent l'empilement. Ces couches sont alors attaquées, de manière classique, par photolithographie. On obtient ainsi la structure prismatique de section trapézoïdale.

L'ensemble ainsi obtenu est recouvert, par épitaxie par jet moléculaire, d'une couche de InP revêtant toute la face supérieure du dispositif à ce stade de la fabrication. Une nouvelle opération de photolithographie permet de pratiquer une ouverture dans la zone recouvrant la face supérieure de l'empilement. Les bords de l'ouverture, constitués par la tranche de la couche électriquement isolante, forment ainsi un puits au fond duquel se trouve la face supérieure de l'empilement. La couche métallique, par exemple du chrome, est ensuite déposée sur la couche électriquement isolante ainsi que sur la face supérieure de l'empilement, pour former la seconde électrode.

En appliquant une tension électrique entre les faces inférieure et supérieure de l'empilement, soit entre les deux électrodes, on y injecte un courant électrique qui engendre le rayonnement laser.

Ces lasers ont pour avantage de pouvoir être construits pour opérer dans une grande partie du spectre infrarouge moyen (de 3 à 20 µm de longueur d'onde environ) en utilisant les mêmes matériaux semi-conducteurs de base.

Des lasers présentant des structures similaires, auxquelles la présente invention peut être appliquée, ont été décrites, notamment, dans les demandes de brevets WO 99/00572 et FR 99 03845.

Le fonctionnement de ces lasers dépend considérablement de la température de l'empilement lors de l'émission. Or, lorsque le laser est activé, une part sensible de l'énergie se transforme en chaleur. Celle-ci est essentiellement dissipée par diffusion dans le substrat. La dissipation est relativement lente, ce qui limite donc considérablement les conditions d'utilisation.

Dans le dispositif réalisé comme décrit ci-dessus, il est avantageux que la couche électriquement isolante soit aussi épaisse que possible, car l'InP est un bon conducteur thermique. Cela permet d'éviter une élévation exagérée de la température. Malheureusement, plus la couche est épaisse, plus il est difficile de maîtriser l'attaque en vue de former la découpe destinée à permettre le contact électrique entre l'électrode et la face supérieure de l'empilement.

En outre, le dépôt de l'InP par épitaxie par jet moléculaire nécessite une opération de nettoyage sous ultra-vide, ce qui est délicat et coûteux.

Par ailleurs, la fonction d'isolation repose sur la qualité d'une barrière Schottky, ce qui est également difficile à maîtriser.

Le but de la présente invention est de permettre la réalisation de lasers dans lesquels la couche électriquement isolante assure une dissipation optimale de la température, de manière reproductible et à un coût raisonnable.

Ce but est atteint grâce au fait que la couche électriquement isolante recouvre totalement lesdites faces latérales, sans déborder sur la face supérieure, et en ce que son épaisseur est égale à au moins un tiers de l'épaisseur de l'empilement. Une telle épaisseur est suffisante pour permettre une bonne diffusion thermique.

Bien que l'empilement soit de faible épaisseur, il forme une protubérance qui fait que l'ensemble présente une structure non planaire. De la sorte, le laser ne peut être fixé sur un support que par son substrat. Or, un montage du laser, indifféremment sur l'une ou l'autre face, simplifie les opérations d'assemblage. Dans les cas où la dissipation thermique joue un grand rôle, il est avantageux de disposer d'un support fortement conducteur de la chaleur, en contact direct avec la couche électriquement isolante . C'est pourquoi, dans un mode particulier de réalisation, la couche électriquement isolante recouvre le substrat au moins dans la zone attenante à l'empilement et présente une épaisseur au moins égale à celle de l'empilement.

De manière avantageuse, l'épaisseur de la couche électriquement isolante est égale à celle de l'empilement. Il est toutefois envisageable, pour certaines applications, de réaliser une couche électriquement isolante dont l'épaisseur est supérieure à celle de l'empilement. Dans ce cas également, la diffusion thermique est améliorée et la planéité de la deuxième face assurée.

Dans un mode de réalisation particulièrement avantageux, le substrat est en matériau semi-conducteur dopé pour le rendre conducteur.

Parmi les différents types de lasers semi-conducteurs à cascade quantique, ceux présentant les caractéristiques suivantes ont donné des résultats particulièrement bons:
- le substrat est formé d'une plaque en phosphure d'indium (InP), dopé au silicium,
- les manteaux sont formés chacun par des couches en un alliage d'arséniure d'indium et de gallium (InGaAs) et un alliage d'arséniure d'indium et d'aluminium,
- la région active est formée d'une succession de couches d'arséniure d'aluminium et d'indium (AllnAs) et d'arséniure d'indium et de gallium (InGaAs), et
- la couche électriquement isolante est en InP.

Dans une première variante, le phosphure d'indium formant la couche électriquement isolante est de type semi-isolant, par dopage au fer.

Dans une autre variante, le phosphure d'indium formant la couche électriquement isolante est de type non dopé.

La présente invention concerne également un procédé de fabrication d'un laser tel que décrit ci-dessus. Des résultats particulièrement intéressants ont été obtenus en appliquant un procédé comportant les opérations suivantes:
- dépôt des couches destinées à former l'empilement,
- dépôt d'une couche de masquage,
- attaque de la couche de masquage en dehors de la zone destinée à former l'empilement,
- attaque des couches destinées à former l'empilement en dehors de la zone masquée,
- dépôt en phase vapeur par procédé chimique à partir d'un composé organométallique (MOCVD) d'une couche électriquement isolante sur les parties non masquées, jusqu'à atteindre une épaisseur au moins égale au tiers de l'épaisseur de l'empilement,
- élimination de la couche de masquage, et
- dépôt d'une couche conductrice, recouvrant notamment l'empilement sur sa face supérieure.

Comme seule la face supérieure du prisme est masquée, il en résulte que les faces latérales sont entièrement couvertes par la couche électriquement isolante alors que la face supérieure est totalement épargnée.

De manière avantageuse, l'opération de dépôt de la couche électriquement isolante s'effectue jusqu'à atteindre une épaisseur sensiblement égale à l'épaisseur de l'empilement.

Afin d'éviter que la couche de matériau isolant ne se dépose sur la couche de masquage, il est avantageux que celle-ci soit réalisée en dioxyde de silicium (SiO₂).

D'autres avantages et caractéristiques de l'invention ressortiront de la description qui va suivre, faite en regard du dessin annexé, dans lequel:
- La figure 1 représente, de manière schématique, un laser correspondant à l'état de la technique, durant différentes étapes de sa fabrication; et
- La figure 2 montre, selon la même approche schématique, un laser selon l'invention à différents stades de sa fabrication.

Afin de faciliter la compréhension de l'invention, un laser de type connu, objet de l'article paru dans la revue SPIE, mentionné plus haut, sera donc décrit de manière succincte, en référence à la figure 1. Sur cette figure, les dimensions des différentes parties constitutives du laser sont choisies pour faciliter la lecture du dessin. Elles ne sont pas significatives des dimensions réelles.

La figure 1a montre une plaque de base, constituant un substrat 10, revêtue d'un empilement de couche 12 qui, après différentes opérations formeront le guide d'onde du laser, constitué d'une région active et de deux manteaux prenant cette dernière en sandwich.

L'empilement 12 porte une couche de masquage 14, la recouvrant localement dans la zone devant être épargnée.

De manière classique, le substrat 10 est réalisé au moyen d'une plaque en monocristal de phosphure d'indium (InP) dopé au silicium. L'empilement 12 est formée d'une alternance de couches d'arséniure d'aluminium et d'indium (AllnAs) et d'arséniure d'indium et de gallium (InGaAs), qui constituent deux manteaux et une région active.

La couche de masquage 14 est en dioxyde de silicium (SiO₂), déposée initialement sur toute la surface, les parties devant être éliminées l'étant par photolithographie. En variante, il est aussi possible de réaliser directement la couche de masquage au moyen de la résine utilisée dans le procédé de photolithographie.

L'ensemble ainsi obtenu est ensuite soumis à une attaque chimique, qui élimine les couches formant l'empilement, à l'exception de la zone masquée. Comme le montre la figure 1b, l'empilement 12 prend alors la forme d'un prisme à section sensiblement trapézoïdale, dont la grande base est en contact avec le substrat 10 et la petite base est recouverte par la couche de masquage 14. Cette dernière est ensuite éliminée, pour obtenir la structure représentée sur la figure 1c. La forme de la section du prisme est définie par les moyens utilisés lors de l'attaque des couches formant l'empilement dans les zones non masquées. Elle n'influence pas le fonctionnement du laser.

Lors de l'opération suivante, illustrée à la figure 1d, toute la surface est recouverte d'une couche électriquement isolante 16 de InP, par épitaxie par jet moléculaire. Cette couche peut être réalisée au moyen de InP aussi pur que possible, c'est-à-dire non dopée. Il est aussi possible d'utiliser de l'InP dopé au fer, pour obtenir une couche de matériau appelé communément semi-isolant, comme décrit dans la publication mentionnée plus haut.

La couche 16 est, ensuite, localement attaquée, par photolithographie, pour dégager une ouverture 18 dans la partie recouvrant la face supérieure de l'empilement. Le tout est, ensuite, recouvert d'une couche en matériau conducteur formant une électrode 20, par exemple du chrome, comme représenté sur la figure 1e.

Dans le dispositif réalisé comme décrit ci-dessus, il est avantageux que la couche électriquement isolante soit aussi épaisse que possible, car l'InP est un bon conducteur thermique. Il est ainsi possible d'éviter une élévation exagérée de la température. Malheureusement, plus la couche est épaisse, plus il est difficile de maîtriser l'attaque en vue de former la découpe destinée à permettre le contact électrique entre l'électrode et la face supérieure de l'empilement.

Le dépôt de l'InP par épitaxie par jet moléculaire nécessite une opération de nettoyage sous ultra-vide, ce qui est délicat et coûteux.

Par ailleurs la fonction d'isolation repose sur la qualité d'une barrière Schottky, ce qui est également difficile à maîtriser.

Enfin, bien que l'empilement soit de faible épaisseur, il forme une protubérance qui fait que l'ensemble présente une structure non-planaire. De ce fait, le substrat ne peut être fixé sur un support que par sa face opposée à celle portant l'empilement.

Si l'on se réfère à la figure 2, on constate que, dans le procédé selon l'invention, les opérations représentées aux figures 1a et 1b se retrouvent à l'identique sur les figures 2a et 2b, avec un substrat 10, un empilement 12 et un couche de masquage 14.

L'opération suivante, illustrée à la figure 2c, consiste à déposer la couche électriquement isolante 22, en conservant la couche de masquage 14. Cette opération s'effectue par dépôt de InP en phase vapeur, par procédé chimique, à partir d'un composé organométallique, plus connu par l'homme du métier sous l'abréviation de MOCVD abréviation de la périphrase anglaise "metal organic physical vapor deposition". Un tel procédé est décrit de manière complète dans l'ouvrage intitulé "Materials Aspects of GaAs and InP Based Srtuctures" de V. Swaminathan et A. T. Macrander, Prentice Hall advanced reference series. ISBN 0-13-346826-7.

Ce procédé permet le dépôt de couches relativement épaisses, recouvrant totalement les faces latérales du prisme jusqu'au contact de la couche de masquage 14. De la sorte, la couche électriquement isolante ne peut déborder sur la face supérieure du prisme. De manière avantageuse, le dépôt est interrompu au moment où l'épaisseur de la couche 22, de InP, est égale à celle de l'empilement 12.

Comme on peut le voir sur la figure 2d, la couche de masquage 14 est ensuite éliminée, puis une couche conductrice 24, par exemple en chrome, est déposée, formant une électrode supérieure de contact.

Le substrat en InP dopé assure la fonction d'électrode inférieure. Aussi, en appliquant une tension entre les deux électrodes, il est possible d'injecter un courant dans l'empilement, pour provoquer l'émission de lumière cohérente.

Il est aussi possible de réaliser une couche électriquement isolante 22 sensiblement plus épaisse que l'empilement 12. Dans ce cas, la face supérieure du prisme se trouvera au fond d'une gorge. Une telle structure permet aussi d'assurer une bonne diffusion thermique. Comme la surface de la face supérieure du prisme est faible par rapport à la surface totale du substrat, l'ensemble ainsi obtenu se présente sous forme d'une plaque dont les deux faces sont planes et parallèles, l'une de ces dernières comportant une gorge au droit de l'empilement.

Il va de soi qu'il est possible de réaliser plusieurs lasers sur un même substrat. Ce dernier peut, ensuite, être découpé en plaquettes, chacune d'elles comportant un ou plusieurs lasers. Ces plaquettes sont disposées sur un support portant également des circuits électroniques de commande, destinés à assurer l'alimentation du laser.

Il est évident que de nombreuses variantes peuvent être envisagées sans pour autant sortir du cadre de l'invention. Ainsi, il est également possible d'utiliser un substrat en matériau isolant, recouvert d'une couche conductrice, cette dernière assurant la fonction d'électrode.

La structure de l'empilement peut, bien entendu, aussi comporter de nombreuses variantes de configurations, par exemples celles décrites dans les demandes de brevet WO 99/00572 et FR 99 03845.

## Revendications

1. Laser semi-conducteur à cascade quantique, comportant
- un substrat (10),
- un empilement (12) de couches, de forme prismatique à section sensiblement trapézoïdale, avec une face inférieure disposée sur le substrat (10), une face supérieure et des faces latérales, ledit empilement formant une région de gain et deux manteaux entre lesquels la région de gain est interposée,
- deux électrodes (10, 24) disposées de part et d'autre de l'empilement (12), dont l'une (24) est formée par une couche de matériau électriquement conducteur recouvrant au moins partiellement la face de l'empilement opposée au substrat, et
- une couche électriquement isolante (22) interposée entre les deux électrodes,
caractérisé en ce que ladite couche électriquement isolante (22) recouvre totalement lesdites faces latérales, sans déborder sur la face supérieure, et en ce que son épaisseur est égale à au moins un tiers de l'épaisseur de l'empilement (12).

2. Laser selon la revendication 1, caractérisé en ce que ladite couche électriquement isolante (22) recouvre ledit substrat (10) au moins dans la zone attenante audit empilement (12) et présente une épaisseur au moins égale à celle de ce dernier.

3. Laser selon la revendication 2, caractérisé en ce que l'épaisseur de la couche électriquement isolante (22) est sensiblement égale à l'épaisseur de l'empilement (12).

4. Laser selon la revendication 3, caractérisé en ce que ledit substrat (10) est en matériau semi-conducteur dopé pour le rendre conducteur.

5. Laser selon la revendication 4, caractérisé en ce que:
- ledit substrat (10) est formé d'une plaque en phosphure d'indium (InP), dopé au silicium,
- lesdits manteaux sont formés chacun par des couches formées d'un alliage d'arséniure d'indium et de gallium (InGaAs) et d'un alliage d'arséniure d'indium et d'aluminium,
- la région active est formée d'une succession de couches d'arséniure d'aluminium et d'indium (AllnAs) et d'arséniure d'indium et de gallium (InGaAs), et en ce que
- ladite couche électriquement isolante (22) est en phosphure d'indium.

6. Laser selon la revendication 5 caractérisé en ce que le phosphure d'indium formant la couche électriquement isolante (22) est de type semi-isolant, par dopage au fer.

7. Laser selon la revendication 5, caractérisé en ce que le phosphure d'indium formant la couche électriquement isolante (22) est non dopé.

8. Procédé de fabrication d'un laser selon l'une des revendications précédentes, caractérisé en ce qu'il comporte les opérations suivantes:
- dépôt des couches destinées à former ledit empilement (12),
- dépôt d'une couche de masquage (14),
- attaque de la couche de masquage (14) en dehors de la zone destinée à former ledit empilement,
- attaque des couches destinées à former l'empilement (12) en dehors de la zone masquée,
- dépôt en phase vapeur, par procédé chimique, à partir d'un composé organométallique (MOCVD), d'une couche électriquement isolante (22) sur les parties non masquées, jusqu'à atteindre une épaisseur sensiblement égale à l'épaisseur de l'empilement (12),
- élimination de la couche de masquage (14), et
- dépôt d'une couche conductrice (24), recouvrant notamment l'empilement (12) sur sa face supérieure.

9. Procédé selon la revendication 8, caractérisé en ce que l'opération de dépôt de la couche électriquement isolante (22) s'effectue jusqu'à atteindre une épaisseur sensiblement égale à l'épaisseur de l'empilement (12).

10. Procédé selon l'une des revendications 8 et 9, caractérisé en ce que ladite couche de masquage (14) est réalisée en SiO₂.
